# EUROPEAN PATENT APPLICATION

(11) **EP 2 148 377 A1**
(43) Date of publication of application: **27.01.2010**
(21) Application number: 08013448.9
(22) Date of filing: 25.07.2008
(51) Int. Cl.: H01L 31/052

(54) **Solar power generating system employing a solar battery**

(71) Applicant: Sakurai, Toshihiko, Tokorozawa-shi Saitama-ken 350-0021 (JP)
(72) Inventor: Sakurai, Toshihiko, Tokorozawa-shi Saitama-ken 350-0021 (JP)
(74) Representative: Prechtel, Jörg

(57) **Abstract**

A solar power generating system employing a solar battery includes a two-dimensional reflector comprising a holder and a sheet-like first solar battery held on the holder. The sheet forms a partially absorptive and partially reflective surface of the reflector. The two-dimensional reflector has a focal line and a mirror axis plane extending along the direction of its length. The system further includes a sun-tracking unit to detect the direction of the sun and to control the two-dimensional reflector to point the mirror axis plane toward the sun. The system further includes a thermally conductive tube extending along the focal line of the two-dimensional reflector, a second solar battery held on an outer surface of the tube with its photo-sensitive surface facing outward, and a cooling and heat supplying unit for circulating fluid through the tube and for supplying obtained heat externally.

## Description

### BACKGROUND OF THE INVENTION

### 1. Field of the Invention

This invention relates in general to a power generating system employing a solar battery, and particularly to a hybrid system configured of a condensation-type generator and a non-condensation-type generator capable of improving energy conversion efficiency by reducing reflection loss of incident sunlight.

### 2. Description of Related Art

Solar power generating systems are known to be clean energy sources that emit no carbon dioxide (CO₂), a harmful greenhouse gas that contributes to global warming. Further, as has been demonstrated with recent solar batteries made of amorphous silicon, the cost of manufacturing solar batteries has been greatly reduced. From these perspectives, a solar power generator employing a solar battery, and particularly condensation-type and reflection-type generators have great potential as a source of clean energy.

However, there are still many problems yet to be solved for power generators employing a solar battery-One of the most critical issues is improving the energy conversion efficiency of the power generator. Further, as such power generating systems become popular, it will become more and more important to make efficient use of limited space, particularly in the cramped conditions of densely populated urban areas. One useful solution to improving energy conversion efficiency is to reduce reflection loss at the surface of the solar battery.

In a conventional open-type solar power generating system, rays of sunlight once reflected off the surface of the solar panel are never re-absorbed by the solar panel. In such a power generating system, the reflected rays of sunlight escape from the system, as disclosed in Japanese Patent Application Publications JP2005-217224A and JP2006-313810A.

There are two types of solar power generating systems. One is a condensation-type system in which rays of sunlight are condensed or converged by a reflector or a lens, then irradiated onto the surface of a solar battery, as are seen in JP2005-217224A and JP2006-313810A. The other type is non-condensation system in which rays of sunlight are allowed to shine directly onto the surface of a solar battery, usually mounted in a flat panel.

The condensation-type system is advantageous because the system can operate with a smaller solar battery, which is an expensive component of the system. Thus, employing a smaller solar battery reduces the manufacturing cost of the overall system. However, when the sunlight is condensed at a higher magnification, the incident rays may become too strong, thus making it difficult to cool the solar battery to keep its temperature low enough far from starting a fatal thermal runaway or causing saturation of the output electrical power, leading to a reduction in photovoltaic conversion efficiency.

### SUMMARY OF THE INVENTION

Accordingly, it is an object of the present invention to provide a solar power generating system employing a solar battery in which highly efficient energy conversion can be achieved by reducing sunlight reflection loss at the surface of the solar battery.

It is another object of the present invention to provide such a system that can be incorporated in the limited space available in densely populated urban areas through such improvements in energy conversion efficiency.

It is still another object of the present invention to provide a hybrid style solar power generating system employing a solar battery combining a condensation-type generator and a non-condensatlon-type generator to achieve high photovoltaic conversion efficiency with low manufacturing costs.

It is yet another object of the present invention to provide a solar power generating system employing a solar battery capable of producing various types of energy derived from solar energy, such as electric power, heat, and kinetic energy of gas.

A solar power generating system employing a solar battery according to one aspect of the present invention includes,
a two-dimensional reflector comprising a holder and a sheet-like first solar battery held on the holder, to form a partially absorptive and partially reflective surface of the reflector, said two-dimensional reflector having a focal line and a mirror axis plane extending along the direction of its length,
a sun-tracking unit for detecting the direction of the sun and controlling said two-dimensional reflector to point said mirror axis plane toward the sun,
a thermally conductive tube extending along said focal line of said two-dimensional reflector.
a second solar battery held on an outer surface of said tube with its photo-sensitive surface facing outward, and
a cooling and heat-supplying unit for circulating fluid through said tube and for supplying obtained heat externally.

A solar power generating system employing a solar battery according to another aspect of the present invention includes,
a two-dimensional reflector comprising a holder and a sheet-like first solar battery held on the holder,
to form a partially absorptive and partially reflective surface of the reflector, said two-dimensional reflector having a focal line and a mirror axis plane extending along the direction of its length,
a sun-tracking unit for detecting the direction of the sun and controlling said two-dimensional reflector to point said mirror axis plane toward the sun,
a transparent tube extending along said focal line of said two-dimensional reflector,
a second solar battery held on an inner surface of said transparent tube with its photosensitive surface facing outward, and
a cooling and heat-supplying unit for circulating fluid inside said tube and for supplying obtained heat externally.

In the hybrid type system of the present invention, rays of incident sunlight will be given a total of three chances to be absorbed by the first or the second solar battery. Only a small portion of the component of incident sunlight will not be absorbed during these three successive opportunities and will escape from the power generator system of the present invention. Therefore, the present invention greatly reduces reflection loss.

Industrial products have long been produced using inexpensive resources, including raw materials and electric power produced in a conventional large-scale thermoelectric power plant. However, in the future, these natural resources, and energy sources in particular, will become more and more expensive. The use of some conventional energy sources; such as petroleum, may even be prohibited to avoid the dangerous possibility of thermal runaway on Earth, as will be explained below. A price of raw materials, especially silicon will rise more and more under huge demand for it.

Under these circumstances, it will become more and more important to use natural or artificial resources efficiently, including raw materials, electric power for manufacturing various components, and spaces in which solar power generator systems are installed. As a result, it is essential to improve the energy conversion efficiency of the power generating system of the present invention.

### BRIEF DESCRIPTION OF THE DRAWINGS

FIG. 1 is a cross-sectional view showing a solar power generating system employing a solar battery according to a first embodiment of the present invention.
FIG. 2 is a partial cross-sectional view of the solar battery sheet 11 in FIG. 1 cut along the direction of its depth.
FIG. 3 is a cross-sectional view showing a solar power generating system employing a solar battery according to a second embodiment of the present invention.
FIGs. 4A and 4B are graphs showing how the density and atmospheric pressure of air at 0% and 100% humidity change along with changes in temperature in order to illustrate how the improved solar power generating system according to the present invention can achieve excellent energy conversion efficiency while being superior to the conventional large scale thermoelectric power plant, which emits or release a large amount of carbon dioxide.

### DETAILED DESCRIPTION OF THE PREFERRED EMBODIMENT

### <Newly developed theoretical analyses for global warming phenomena>

Before describing the preferred embodiments of the present invention, it should be fully understood why the solar power generating system and its improvement is indispensable now. Namely, by continuing to release carbon dioxide into the atmosphere, humankind runs the risk of further contributing to global warming. Allowing the further progression of global warming could trigger thermal runaway on Earth due to the wet greenhouse effect, which in turn would drastically accelerate the rate of global warming.

About two decades ago, astrophysicist John Gribbin suggested that in the future we would face a dangerous phenomenon in which the water vapor on Earth acts as a greenhouse gas. He called the phenomenon a thermal runaway by "wet" greenhouse effect (Hothouse Earth: the Greenhouse Effect and Gaia, John Gribbin, Bantam Press, London, New York, Sydney, Auckland). Gribbin explained that this phenomenon might have been responsible for changing ancient Venus into the incandescent planet we know today reaching surface temperatures of up to 480 degree centigrade (°C). He also introduced the results of a numerical calculation performed by James Kasting, et al., at NASA's Ames Research Center. The numerical calculation told us that the thermal runaway could occur on the Earth if the solar constant (a density of solar radiation) were to increase by 10 per cent.

Astrophysicists have known for the past few decades that water vapor acts as a greenhouse gas. The artificial satellite Nimbus 4 recorded a spectrum of infrared radiation from the Earth in which absorbent bands of infrared rays of water vapor were observed together with that of carbon dioxide. The Chronological Scientific Tables 2004, published by the National Astronomical Observatory of Japan, gives data to describe absorbent bands of infrared rays of water vapor: Structural chemistry - molecular spectroscopic character.

John Gribbin and James Lovelock have pointed out that; according to astronomers, the solar constant has been increasing by 4 percent every hundred million years. The solar constant might have reached the threshold for the thermal runaway by the wet greenhouse effect on ancient Venus because the distance between Venus and the Sun is about 70 percent that between the Earth and the Sun. Thus the solar constant on Venus is almost twice (≒ 1/(0.7)²) that on the Earth. This also means that the solar constant on the Earth has been following in the path of on Venus with a delay time of 1.8 billion years, because 1/(0.7)²≒2 ≒(1.04)¹⁸

On Venus at the time, a rise in the temperature of the sea surface increased the density of water vapor in the air over the sea. This increased density of water vapor intensified the wet greenhouse effect, leading to a further rise in the temperature of the sea surface. This process is called a positive-feedback process in which the effect enhances the cause. A positive feedback process is known as a vicious circle because the process can run dangerously out of control. Moreover, it is well known that the amount of water vapor in the air increases at an increasing tempo or exponentially as temperature rises. As a result of the positive feedback process on Venus, the surface temperature of the seas began to rise unrestrainedly, and all the sea water evaporated and lost.

The results of the numerical calculation performed by James Kasting, et al. described above, tell us that we still have a margin of about 250 million years before the thermal runaway would start. However, there are some phenomena that cause an increase of the solar constant substantially or equivalently in the cases of determining surface temperature on the Earth. For example, a decrease in reflection ratio of the Earth against the rays of sunlight by a few percent caused by a decrease in an area of snowy or icy surfaces or an amount of clouds or aerosols in the sky which reflect or scatter the sun, respectively results in an equivalent increase in the solar constant for the same ratio, respectively.

As the density of carbon dioxide in the air increases, the surface temperature of the Earth rises slightly due to the weak greenhouse effect from the carbon dioxide, and in turn this rise in temperature increases the density of water vapor in the air to enhance the greenhouse effect. Thus, the weak greenhouse effect caused by the carbon dioxide will be amplified by the strong greenhouse effect caused by the increased amount of water vapor by several tens of times or more, depending on the temperature of the sea surface.

Therefore, any other factors causing an artificial rise in the temperature of the sea surface, i.e., releasing artificial heat on the surface of the Earth will have the same result in that they all lead to an artificial increase of water vapor in the air. The effect of releasing artificial heat all over the world will induce a greenhouse effect of water vapor to cause confining on the order of one percent of total incident solar rays on the surface of the Earth. The global warming will continue until artificial energy source including atomic energy are replaced with natural energy sources derived from current solar energy. This recognition of this problem leads to a very important conclusion in that power generation from atomic energy may not be a solution to curb the progression of global warming.

According to the most important new concept of the present inventor, "weakened convection (or circulation) of hot wet air" under high temperature will trigger thermal runaway through the wet greenhouse effect. This will be described below.

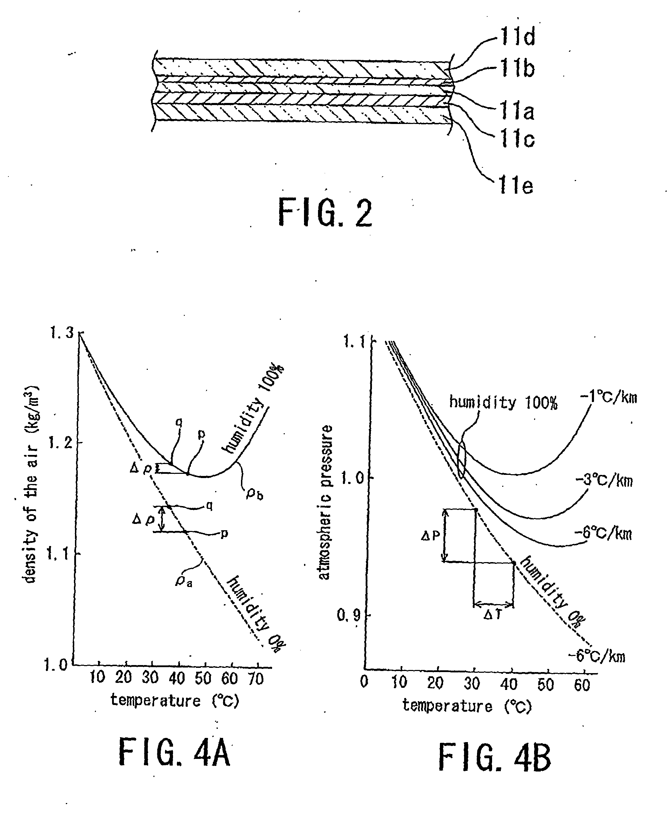

Referring to FIG. 4A, the dotted line illustrates the dependence of the density of dry air ρₐ (Kg/m³) on temperature, while the solid line in FIG.4A illustrates the dependence of the density of humid air ρ_{b} (Kg/m³) on temperature, under 1 atmospheric pressure (1atm) in both cases. Here, the dry air denotes completely dry air of 0 percent relative humidity and the humid air denotes completely humid air of 100 percent relative humidity. The distance between the solid line and the dotted line along the vertical axis i.e., a deference of density (*ρ*_{b} - *ρ*ₐ) (Kg/m³) under the same temperature denotes the maximum value of water vapor that can be contained in the completely humid air of a volume of 1 m³ under 1 atm and is called the saturated amount of water vapor *ρ*_{w} (Kg/m³) at any temperature, as is well known.

The density of dry air *ρ*ₐ decreases as temperature rises, as is indicated by the dotted line, because dry air expands and becomes thinner. The density of water vapor *ρ*_{w} which can be contained in humid air increases at an accelerated rate as temperature rises, compensating for the decrease in the density of the dry air *ρ*ₐ and eventually effecting an overall increase in the density of the humid air *ρ*_{b} above a temperature of about 45°C Thus the manner in which the density of air changes along with changes in temperature differs depending on whether the air is dry or humid, i.e., depending on whether the air is located above dry inland or wet sea. The behavior of the humid air is more important than that of the dry air, because almost 3/4 of the surface of the Earth is covered with the water.

Starting from the relation between the temperature T and the density *ρ* of the air at altitude zero under 1 atm illustrated in Fig.4A, a relation between temperature T and atmospheric pressure P at any location at altitude zero of temperature T can be calculated according to a definition of atmospheric pressure which is a total weight of atmosphere(Kg) existing above the area of 1 cm² and is normalized by a value 1.013 Kg/cm² referred to as standard value of atmospheric pressure(1013millibar or 1atm). In the calculation, approximations were made that atmospheric pressure decreases by nearly half for every 5000-meter increase in altitude, and that the temperature of the atmosphere drops linearly with an increase in the altitude with a coefficient of about 6-8°C for every 1000-meter increase in altitude under normal cases. The coefficient is referred to as a lapse rate, in the field of meteorology.

The result of the calculation described above is shown in FIG.4B. A dotted line denotes the atmospheric pressures at location at altitude zero of temperature T, above which atmosphere of dry air exists, under the lapse rate of -6°C/km. Solid curved lines indicate atmospheric pressures at locations at altitude zero of temperature T above which atmosphere of humid air exist, under various assumed lapse rates of -6°C/km, -3°C/km and -1°C/km, respectively.

The atmospheric pressure P have been calculated based on an atmospheric model assuming an imaginary static state with no convection or circulation. When convection is taken into account, the difference in atmospheric pressure ΔP between different locations of different temperatures with a difference of ΔT will be much less. This static state can be assumed under imaginary situations, for example a viscosity of the air or a frictional resistance between the air and the sea surface is large enough to prevent a convection in the air from occurring. Although the imaginary situations are assumed, the curves plotted in FIG. 4B are sufficiently useful to evaluate how real convection in the atmosphere weakens as temperature rises.

From a global point of view, in the Northern hemisphere, the sea surface located in the South receives a greater amount of solar energy and has a higher temperature T and lower atmospheric pressure P to produce ascending current than the sea surface located in the North. Excess heat is transferred from the location in the South to the location in the North by convection or circulation in the atmosphere. Referring to Fig. 4B, the difference in atmospheric pressure ΔP between two locations having different temperatures with a difference of ΔT at the sea surface separated in the North-South direction acts as a motive force (or power) for driving the convection in the atmosphere between these two locations.

The path of the convection, passing the two locations, may be a closed loop or an open path that links to another path of convection. As a global distance ΔL between two locations separated in the North-South direction increases, the difference in temperature AT between the two locations also increases. Accordingly, the distance ΔT along the horizontal axis in FIG. 4B can be considered to represent the global distance ΔL in the North-South direction.

As AT increases, the motive force ΔP for driving convection also increases. However as AT, hence ΔL, increases, a frictional resistance inside the air and between the air and sea surface (or a load against the motive force ΔP) also increases, weakening convection between the two locations. As a result, the strength or activity of convection in the air can be roughly evaluated by the slope ΔP/ΔT of a tangent to the solid or dotted curves for any temperature in FIG. 4B. As the temperature rises, the activity of convection ΔP/ΔT decreases more and more. The convection above the sea weakens further comparing to the convection above a dry inland, because the density of the humid air on the hot sea surface (a load against the motive force ΔP) is larger than that of dry air.

It has been thought that as global warming develops, the convection in air above the ocean will become increasingly active, producing massive tropical storms capable of threatening human life. In fact, as the temperature of the sea surface rises, the convection in the atmosphere itself weakens above the ocean because the activity of convection ΔP/ΔT decreases, as is shown in FIG.4B. However, the amount of latent heat (heat of vaporization and condensation of water) transferred by water vapor into the atmosphere above a location of low atmospheric pressure increases. At about 30°C. the large water vapor content in the humid air will supply a great amount of latent heat to the air. This heat will be converted to an huge amount of kinetic energy of the air, generating powerful tropical storms. Most of the kinetic energy produced will be changed finally into a frictional heat produced by friction between the air and the surface of the Earth and will be returned to the surface of the Earth.

However, as the surface temperature of the sea continues to rise, the strength of convection ΔP/ΔT decreases too much to supply latent heat to the air, weakening the function of convection to disperse or transfer heat from the sea surface into the air and from the South to the North. This phenomenon is confirmed by the fact that a number of cyclones produced in the Northern hemisphere of the Indian Ocean decreases during the hottest period of the year, i.e., from July to September.

During the early summer in Japan, a hot and strong high atmospheric pressure generated over the Pacific Ocean near Japan pushes up Baiu-front to the north and covers a large portion of the Japanese Islands, bringing an end to the rainy season and a start to the hot weather of midsummer. This hot and strong high atmospheric pressure is produced because a strong ascending current generated over the Pacific Ocean east of the Philippines moves North by about 1000 km, descending onto the Pacific Ocean Southeast of Japan.

In recent years, there has been a tendency for the end of rainy seasons to be delayed, in Japan. The Meteorological Agency of Japan has been explaining that the cause of this delay is an inactiveness of convection above the Pacific Ocean near the Philippines that produces the hot, high atmospheric pressure over the Pacific Ocean near Japan, and that this inactiveness may be related to the advance of global warming, and that the exact relation between the inactiveness and the advance of global warming is not clear.

However, this phenomenon can be explained with the inventor's theory described above, i.e., that the convection in the atmosphere and the ascending current of humid air become inactive as the surface temperature of the ocean rises. This theory is confirmed by the fact that the phenomenon becomes clear when 1a Niña occurs and the temperature of the sea surface near the Philippines is about 2°C higher than in other years, as was the actual case in 2007.

According to the inventor's new theory, the weak ascending current, which is the most important aspect of the weakened convection, is the phenomenon most likely to trigger the fatal thermal runaway.

Under normal conditions, a strong ascending current expands rapidly while rising in the sky under atmospheric pressure falling rapidly as altitude increases, without a chance for receiving external heat, and hence cools down when its own heat is converted into kinetic energy for expansion. This phenomenon is called adiabatic expansion and adiabatic cooling and forms the normal lapse rate in the sky. However, as the ascending current of humid air weakens, the current will begin to ascend much slowly taking much longer time than normal, such as a half-day, whole day, or even several days. Thus, water vapor and carbon dioxide contained in the weak ascending current will have a greater chance to absorb large amounts of rays of infrared radiated from the hot sea surface or from condensing water vapor in the atmosphere.

The absorbed heat is transferred to the ascending air almost instantaneously through frequent collisions between component molecules, i.e., nitrogen, oxygen, water and carbon dioxide to approach thermal equilibrium between various gasses, because molecules are moving around fast at own thermal velocities of few hundred meters per second, to warm whole the air. This absorption and transfer of heat greatly weakens the function of adiabatic cooling so that the air at high altitudes begins to maintain its warm temperature. Thus water vapor begins to reach high altitudes without condensation due to the warm temperature. This increased amount of water vapor in the atmosphere enhances the greenhouse effect.

The humid air that remains above the hot sea surface prevents a drop in atmospheric pressure, causing the ascending current to weaken more and more through the positive feedback process. As a result, the absolute value of the lapse rate becomes smaller and smaller. For this reason, the example of the abnormally small lapse rate of -1°C/km is illustrated in FIG. 4(B).

At high altitudes, the amount of water vapor decreases, because the atmospheric pressure drops and the water vapor expands becoming thinner. Therefore, fewer droplets are produced when the water vapor condensates, preventing the formation of thick clouds. In other words, clouds will be formed thinner at higher altitudes and will consequently lose their function of blocking the rays of incoming sunlight by reflection or absorption. A decrease in an amount of clouds in high altitude will promote the thermal runaway by increasing an amount of rays of sunlight reaching the sea surface and heating it, while most of infrared rays radiated from the hot sea surface will be absorbed by the water vapor and carbon dioxide in the air before reaching the clouds in the high altitude. Therefore, a function of clouds for blocking sunlight will be greater than that for confining heat.

Recently, an increasing number of glaciers is melting at an increasing rate, producing numerous lakes that have been precariously dammed up with fragile structures in high mountainous regions throughout the world. The melting of the glaciers may be the result of the decrease in the amount of clouds that have served to shield the glaciers from incoming rays of sunlight. It may also be possible that global warming is developing faster at high altitudes than it is near the surface of the Earth, which means that the absolute value of the lapse rate may be decreasing.

A lot of phenomena to promote thermal runaway occur through a positive feedback process. For example, as the ascending current weakens, it becomes increasingly difficult for the current to carry aerosols high in the sky by pumping them up. In a middle of the wide Ocean, the aerosols are mainly particles of salt and droplets of sulphuric acid, around which droplets of water are produced to form clouds in the sky. According to James Lovelock, The sulphuric acid is mainly derived from dimethylsulfide produced by biological activity of microorganism, which weakens more and more as the temperature of the sea surface rises. Consequently, an amount of clouds in the sky decreases and temperature of the sea surface continues to rise, causing the ascending current to weaken further.

Thermal runaway caused by the wet greenhouse effect will start only temporally and locally in its early stage. It will start above a tropical ocean at a latitude of less than 5 degrees, where the temperature of the sea surface is always high and the Coriolis force is too weak to produce turbulences to grow into tropical storms that interrupt the start of the thermal runaway by carrying accumulated heat out of the area to nullify an abnormal lapse rate being formed above the area.

Although thermal runaway will occur only temporally and locally in its early stage, a large amount of heat confined in the air will be absorbed in the sea surface layer and will be steadily accumulated there, because the sea surface layer acts as a good absorber and accumulator for heat.

As described above, we cannot completely discount the thermal runaway on the Earth caused by the wet greenhouse effect. Hence it is highly desirable to replace our energy sources entirely with rays of sunlight and natural sources derived from the current solar energy, i.e., wind energy, wave energy, as Europeans especially Germans are already trying.

The amount of solar energy necessary for human activity will be on the order of 0.01 percent of the total incident solar energy. Dependence on bio-ethanol will conflict with the security of a stable food supply in addition to the problem that not a little fuel is required to produce it. Wind and wave energy will decrease as convection weakens. The solar power generating system employing solar battery will be the best choice for using natural energy sources. This conclusion is based on the inventor's theory explained above in detail.

### <First Embodiment>

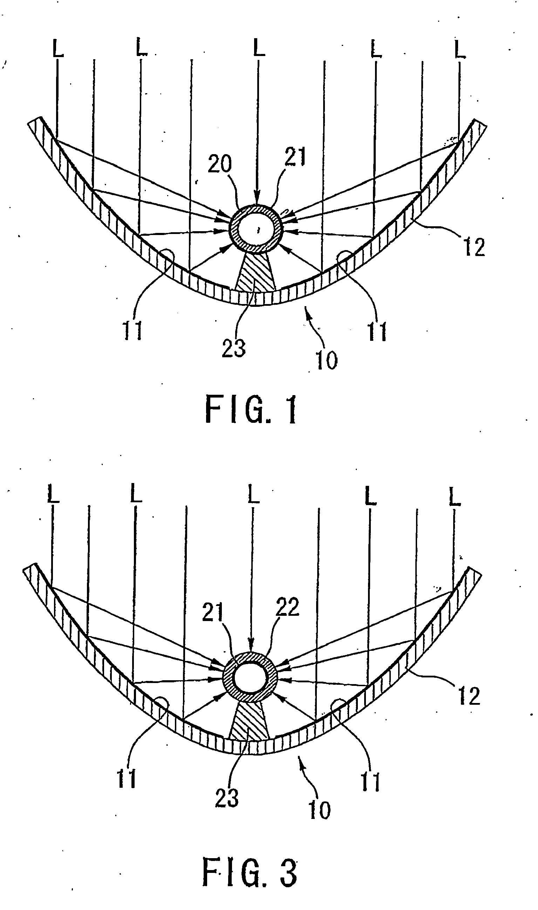

FIG. 1 is a cross-sectional view showing a solar power generating system employing a solar battery according to a first embodiment of the present invention. The straight lines in this figure indicate rays of incident or reflected sunlight.

The generator system of the first embodiment includes a two-dimensional reflector 10, a sheet-like first solar battery 11, a holder 12, a sun-tracking unit (not shown in the figure), a metal tube 20, a second solar battery 21, and a cooling and heat supplying unit (not shown in the figure).

The two-dimensional reflector 10 has the solid holder 12, which is formed of plastic, and the solar battery sheet 11, which is flexibly attached and fixed cohesively to the inner surface of the solid holder 12. The holder 12, and thus the solar battery sheet 11 and the reflector 10, has a gutter-like two-dimensional shape. As is shown in FIG. 1, the inner surface of the two-dimensional reflector 10 has a parabolic shape focusing the rays of sunlight and a mirror axis above the inner surface.

The two-dimensional reflector 10 also has a focal line and a mirror axis plane extending along the direction of its length. The focal line is assumed to be a line that connects the focal point in each cross-sectional plane. The mirror axis plane is assumed to be a plane that connects the mirror axis in each cross-sectional plane. In FIG. 1, the focal line and the mirror axis plane are assumed to extend in the direction perpendicular to the plane of the drawing.

The sun-tracking unit detects the direction of the sun moving from east to west and controls the attitude of the two-dimensional reflector 10 using an appropriate motor and transmitter (not shown in the figure) to maintain the mirror axis plane in a direction pointing toward the sun.

The metal tube 20 is attached to the holder 12 by a supporting leg 23 and extends along the focal line of the two-dimensional reflector 10.

The second solar battery 21 is fixed around the outer surface of the metal tube 20 and has a photo-sensitive surface facing outward. The second solar battery 21 is divided into a plurality of ring-shaped segments along the focal line. Each segment is fixed around the outer surface of the metal tube 20 by solder bonding to maintain good thermal contact with the metal tube 20.

The cooling and heat-supplying unit supplies a flow of water through the metal tube 20 to cool the same. Heat absorbed from the tube 20 is subsequently supplied to an appropriate mechanical power generator, a heat supplier, or a hot water supplier outside the tube 20.

FIG. 2 is a partial cross-sectional view showing part of the sheet-like first solar battery 11 of FIG. 1. The cross section of the first solar battery 11 is taken along the direction of its thickness. The first solar battery 11 has a protective plastic film 11e constituting the bottom layer; an under metal electrode layer 11c formed on the protective plastic film 11e; a semiconductor photovoltaic power generator film 11a formed on the under metal electrode layer 11c and having an amorphous silicon layer in which a PN junction is formed in parallel to the layer 11c; a transparent upper electrode layer 11b formed on the semiconductor photovoltaic film 11a; and a transparent plastic protective film 11d covering the surface of the transparent upper electrode layer 11b.

The photovoltaic electric power generated inside the semiconductor photovoltaic film 11a is subsequently supplied outside the solar battery sheet 11 through internal electrodes (not shown in FIG. 2). Rays of incident sunlight impinging on the solar battery sheet 11 are mostly absorbed and partially reflected thereby. In other words, the sheet 11 functions as a mostly absorptive and partially reflective solar battery sheet for the incident sunlight.

The shape of the two-dimensional reflector 10 and a dielectric constant of the surface of the solar battery sheet 11 are set so that the incident angle of sunlight rays does not exceed the Brewster angle for total reflection. Most of the rays of incident sunlight will be absorbed in the first solar battery sheet 11. The rest, i.e., the rays of sunlight reflected off the surface of the two-dimensional reflector 10 will proceed toward the photosensitive surface of the second solar battery 21.

The second solar battery 21 is formed of a wide gap semiconductor material, for example, a III-V or IV-IV compound semiconductor such as GaAs or SiC, with consideration for the working condition of the material at high temperatures.

Assuming that the reflection ratio of incident rays is 20 percent at the surface of the solar battery sheet 11 and the ratio of surface area on the two-dimensional reflector 10 to that of the second solar battery 21 is 30, the density of incident rays at the surface of the second solar battery 21 will be six times the density of incident rays at the surface of the solar sheet 11. Therefore, the temperature inside the second solar battery 21 will be fairy high, even when accounting for the cooling function implemented by the metal tube 20 and the cooling and heat-supplying unit.

In the present invention, SiC is the most preferable compound semiconductor material for use in the solar battery 21 from among the various wide band gap semiconductors. Compared to silicon, silicon carbide has up to three times the thermal conductivity, as high as ten times the breakdown voltage, and as much as twice the electron saturation drift velocity.

Since the rays of incident sunlight reflected off the surface of the reflector 10 proceed toward the center of the metal tube 20, the reflected rays of sunlight will impinge on the surface of the second solar battery 21 at a near perpendicular angle and will be absorbed in the photosensitive surface of the second solar battery 21 without any occurrence of total reflection. Only a small portion of these incident rays will be reflected again off the surface of the second solar battery 21, but these rays will return along a path nearly the same as the incoming path.

Thus, rays reflected off the second solar battery 21 once again impinge on the surface of the first solar battery 11 and are thus given one more chance to be absorbed therein. Here, the outgoing path from the first solar battery 11 and the return path from the second solar battery 21 will not be exactly the same. Therefore, the second impinging position on the first battery 11 will not be the same as the first position, preventing the rays from being reflected again for the same reason, for example, due to a scar or small irregularity formed in the surface of the first solar battery 11.

Only a small amount of component rays again reflected off the surface of the first solar battery 11 will escape the power generator system in FIG. 1, producing only minute reflection loss. Thus, the present power generator system minimizes reflection loss because the rays of sunlight are given three chances to be absorbed into the surface of either the first or second solar battery 11 or 12 before escaping.

A portion of the component rays of sunlight absorbed into the second solar battery 21 will lose the chance to be converted into electric power and will be converted to heat inside the solar battery 21. However, this heat can be utilized directly through the cooling and heat supplying unit and appropriate equipment not shown in the figures. Such a subsystem will have good compatibility with a hot water supply system utilizing inexpensive midnight excess electric power, which systems have recently become popular in Japan.

A portion of the heat produced inside the second solar battery 21 will be used as kinetic power, or further converted to electric power with a dynamo, through the cooling and heat supplying unit and other appropriate equipment, such as the dynamo, not shown in the figures. Therefore, energy utilization efficiency will be improved.

It is possible to use a thin ceramic tube, instead of the metal tube 20 in a variation of the first embodiment.

### <Second Embodiment>

FIG. 3 is a cross-sectional view showing a second embodiment of the power generator system according to the present invention. In the figure, elements having identical reference numbers to those in the first embodiment are the same elements that have been described with reference to FIGs. 1 and 2. Therefore, a duplicate description of these elements will be avoided.

In the system shown in FIG. 3, a transparent tube 22 formed of silica glass extends along the focal line and the mirror axis plane of the two-dimensional reflector 10 in place of the metal tube. The second solar battery 21 is disposed inside and held by the inner surface of the transparent tube 22. The second solar battery 21 is divided along the focal line into a plurality of ring-shaped segments or along the peripheral direction into a plurality of plate-shaped segments. Each segment is held on the inner surface of the transparent tube 22 with its photosensitive surface facing outward.

Although the present invention has been described herein with respect to preferred embodiments thereof, the foregoing description is intended to be illustrative, and not restrictive. Those skilled in the art will realize that many modifications of the preferred embodiment could be made which would be operable. All such modifications, which are within the scope of the claims, are intended to be within the scope and spirit of the present invention.

A solar power generating system employing a solar battery includes a two-dimensional reflector comprising a holder and a sheet-like first solar battery held on the holder. The sheet forms a partially absorptive and partially reflective surface of the reflector. The two-dimensional reflector has a focal line and a mirror axis plane extending along the direction of its length. The system further includes a sun-tracking unit to detect the direction of the sun and to control the two-dimensional reflector to point the mirror axis plane toward the sun. The system further includes a thermally conductive tube extending along the focal line of the two-dimensional reflector, a second solar battery held on an outer surface of the tube with its photo-sensitive surface facing outward, and a cooling and heat supplying unit for circulating fluid through the tube and for supplying obtained heat externally.

## Claims

1. A solar power generating system employing a solar battery comprising:
a two-dimensional reflector comprising a holder and a sheet-like first solar battery held on the holder, to form a partially absorptive and partially reflective surface of the reflector, said two-dimensional reflector having a focal line and a mirror axis plane extending along the direction of its length,
a sun-tracking unit for detecting the direction of the sun and controlling said two-dimensional reflector to point said mirror axis plane toward the sun,
a thermally conductive tube extending along said focal line of said two-dimensional reflector,
a second solar battery held on an outer surface of said tube with its photo-sensitive surface facing outward, and
a cooling and heat-supplying unit for circulating fluid through said tube and for supplying obtained heat externally.

2. The solar power generating system employing a solar battery as claimed in claim 1, wherein said second solar battery is formed of GaAs.

3. The solar power generating system employing a solar battery as claimed in claim 1, wherein said second solar battery is formed of SiC.

4. The solar power generating system employing a solar battery as claimed in claim 1, wherein said second solar battery is divided along said focal line into a plurality of ring-shaped segments.

5. The solar power generating system employing a solar battery as claimed in claim 1, wherein said second solar battery is divided along the peripheral direction of said tube into a plurality of plate-shaped segments.

6. A solar power generating system employing a solar battery comprising:
a two-dimensional reflector comprising a holder and a sheet-like first solar battery held on the holder, to form a partially absorptive and partially reflective surface of the reflector, said two-dimensional reflector having a focal line and a mirror axis plane extending along the direction of its length,
a sun-tracking unit for detecting the direction of the sun and controlling said two-dimensional reflector to point said mirror axis plane toward the sun,
a transparent tube extending along said focal line of said two-dimensional reflector,
a second solar battery held on an inner surface of said transparent tube with its photosensitive surface facing outward, and
a cooling and heat-supplying unit for circulating fluid inside said tube and for supplying obtained heat externally.

7. The solar power generating system employing a solar battery as claimed in claim 6, wherein said second solar battery is formed of GaAs.

8. The solar power generating system employing a solar battery as claimed in claim 6, wherein said second solar battery is formed of SiC.

9. The solar power generating system employing a solar battery as claimed in claim 6, wherein said second solar battery is divided along said focal line into a plurality of ring-shaped segments.

10. The solar power generating system employing a solar battery as claimed in claim 6, wherein said second solar battery is divided along the peripheral direction of said tube into a plurality of plate-shaped segments.
